# EUROPEAN PATENT APPLICATION

(11) **EP 1 684 323 A1**
(43) Date of publication of application: **26.07.2006**
(21) Application number: 05112864.3
(22) Date of filing: 23.12.2005
(51) Int. Cl.: H01J 17/49, H01J 17/16, H01J 17/34

(54) **Plasma display device**

(30) Priority: 20.01.2005 KR 2005005301
(71) Applicant: Samsung SDI Co., Ltd., Suwon-si Gyeonggi-do (KR)
(72) Inventor: KIM, Sok-San, Kyeonggi-Do (KR); KIM, Dong-Hwan, Kyeonggi-Do (KR); AHN, Joong-Ha, Kyeonggi-Do (KR); KIM, Jae-Gyoung, Kyeonggi-Do (KR)
(74) Representative: Hengelhaupt, Jürgen

(57) **Abstract**

A display device which has a simplified assembly process and minimized product damage. The display device includes a display panel (10); a chassis base (20) having a first surface for supporting and for fixing the display panel thereto; a circuit board (30) fixed to a second surface of the chassis base, the circuit board (30) having circuit elements for driving the display panel; and at least one main fastening unit (40) for fixing the circuit board to the chassis base such that a gap is formed between the circuit board (30) and the chassis base (20). The main fastening (40) unit includes a main body, fasteners, and first and second protrusions to form engaged portions. The display device may be a plasma display device.

## Description

### BACKGROUND OF THE INVENTION

### TECHNICAL FIELD

The present invention relates to a display device, and more particularly, to a plasma display device capable of easily fastening a circuit board.

### RELATED ART

Recently, various types of display devices have been researched and developed, for example, plasma display devices. Generally, a plasma display device implements a desired image using plasma discharge.

Such a plasma display device includes a plasma display panel (PDP) on which desired images are displayed by supplying power to the PDP. The device also includes a chassis base to support the PDP on a front surface thereof, and a circuit board mounted on a rear surface of the chassis base for driving the PDP.

In some cases, a front case and a rear case are coupled respectively at the front and rear of the plasma display module. Further, the front case has an opening such that a user can see images output from the PDP.

In order to assemble the plasma display device, screw fasteners have been used as fasteners for many of the components. In particular, when the circuit board is fastened to the chassis base, screw fasteners are often used.

However, when components are fastened using screw fasteners, much time is needed for fastening the components since the components are fastened by rotating the screw fasteners with proper torque. Therefore, reducing the time necessary for fastening the components would reduce the time for assembling the components, resulting in improved productivity.

When the circuit board is fastened to the chassis base using screw fasteners, the user may operate the screw fastener incorrectly causing damage to the components. Therefore, if a safe fastening method is developed as an alternative to the screw fastener, it is possible to improve the quality of the plasma display device.

### SUMMARY OF THE INVENTION

A display device is provided that is capable of being assembled with a simplified fastening method resulting in reduced product damage during the fastening process.

According to one embodiment of the present invention, a display device is provided including: a display panel; a chassis base for supporting and for fixing the plasma display panel on a first surface; a circuit board fixed on a second surface opposite the first surface of the chassis base, the circuit board having circuit elements for driving the plasma display panel; and at least one main fastening unit holding the circuit board at a set height and fixing the circuit board to the chassis base. The main fastening unit includes a main body fixed on the chassis base, and a plurality of fasteners which extend from the main body wherein neighboring fasteners are separated by a gap. Engageable portions are provided on outer circumferential surfaces of the fasteners such that the fasteners are insertable into the fastening hole of the circuit board to be fastened.

In one exemplary embodiment, each of the fasteners includes a first protrusion which passes through fastening hole of the circuit board to apply pressure to the chassis base, and a second protrusion which contacts an interfacial surface of the circuit board to support the circuit board with the engaged portion interposed between the first and second protrusions.

Further, an auxiliary fastening unit may be provided between the two main fastening units so as to fix the circuit board on the chassis base.

Furthermore, the auxiliary fastening unit may include a boss provided between the fastening units of the chassis base, and a screw fastenable to the boss. A height of the boss may be lower than the set height of the circuit board fixed by the fastening units such that the circuit board is further pressed against the first and second protrusions.

The main fastening units and the auxiliary fastening unit may be made of metallic material to electrically connect the circuit board to the chassis base.

Additionally, a method is provided for spacing and fastening in place a chassis base to a circuit board. The method includes providing a main fastening unit including a main body fixable to the chassis base and a plurality of fasteners extending from the main body, fixing the main fastening unit to the chassis base; and inserting the main fastening unit into a main fastening hole in the circuit board to allow the engageable portions to engage the circuit board.

### BRIEF DESCRIPTION OF THE DRAWINGS

FIG. 1 is an exploded perspective view showing a plasma display device according to an embodiment of the present invention.

FIG. 2 is a cross-sectional view showing a main fastening unit in the plasma display device according to an embodiment of the present invention.

FIG. 3 is a cross-sectional view showing the main fastening unit and an auxiliary fastening unit of the plasma display device according to an embodiment of the invention.

### DETAILED DESCRIPTION

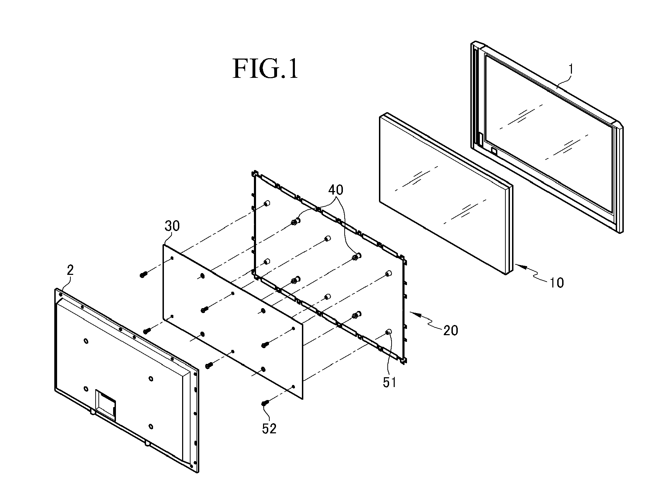

Referring to FIG. 1, a plasma display device includes a plasma display panel 10 (PDP), a chassis base 20, a circuit board 30, and at least one main fastening unit 40. In addition, a front case 1 and a rear case 2 are respectively coupled at a front side and a rear side of a plasma display module which is constructed by coupling the plasma display panel 10, the chassis base 20, and the circuit board 30 sequentially.

The PDP 10 displays a desired image through plasma discharge. The chassis base 20 has a first surface fixed on a rear surface of the PDP 10 to support the PDP 10. The circuit board 30 is provided on a second surface opposite the first surface of the chassis base 20 to drive the PDP 10.

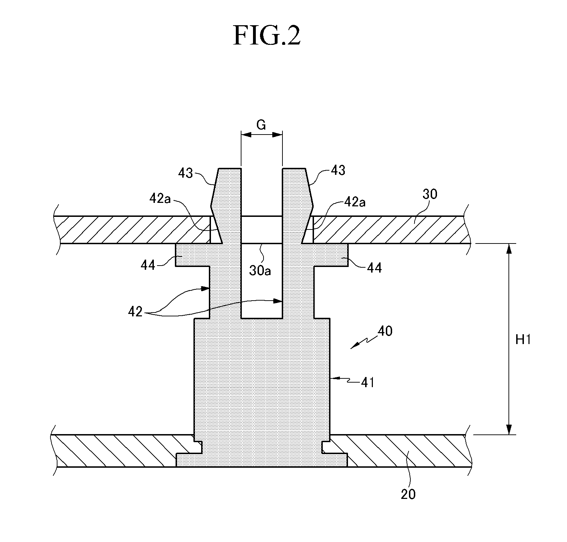

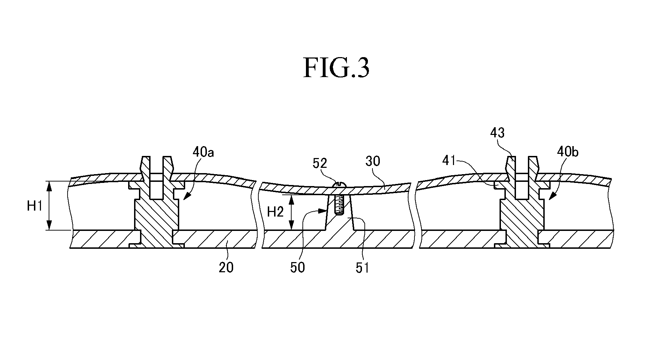

The main fastening unit 40 fixes the circuit board 30 to the chassis base 20 separated by a height H1 (shown in FIG. 2). The circuit board 30 is spaced from the chassis base 20 to prevent electronic components of the circuit board 30 from being short-circuited if they make contact with the metallic chassis base 20. As described in more detail below referring to FIG. 3, screws 52 may engage bores 51 to further secure the circuit board 30 to the chassis base 20

FIG. 2 is a cross-sectional view showing the main fastening unit in the plasma display device according to an exemplary embodiment of the invention.

Referring to FIG. 2, the main fastening unit 40 includes a main body 41 fixed on the chassis base, and fasteners 42 extending from the main body 41 with a gap G formed therebetween.

The gap G is formed between the fasteners to make the fasteners 42 insertable into the fastening hole 30a of the circuit board 30 since the fasteners 42 are forced toward each other when the fasteners 42 are inserted into a fastening hole 30a.

In addition, engageable portions 42a are provided on the outer circumferential surfaces of the fasteners 42 such that the fasteners 42 are insertable into the fastening hole of the circuit board. First and second protrusions 43, 44 are formed with the engaged portions 42a interposed therebetween.

Therefore, when the fasteners 42 are inserted into the fastening hole of the circuit board 30, the first protrusions 43 pass through the fastening hole of the circuit board 30 to apply pressure to the chassis base, and the second protrusions 44 come in contact with a surface of the circuit board 30 to support the circuit board.

The plasma display device includes the main fastening unit 40 so that the circuit board 30 can be assembled with the chassis base 20 without additional screw coupling. That is, an assembly process may be simplified and the percentage of defective units may be reduced.

Further, the main fastening unit 40 may be made of metallic materials such that the circuit board 30 is electrically connectable to the chassis base 20.

FIG. 3 is a cross-sectional view showing two main fastening units and an auxiliary fastening unit in the plasma display device according to another exemplary embodiment of the invention. Although two main fastening units are shown, there may be more than two fastening units.

The auxiliary fastening unit 50 is provided between the first and second fastening units 40a, 40b for fixing the circuit board 30 to the chassis base 20.

The auxiliary fastening unit 50 includes a boss 51 formed on the chassis base 20 between the first and second fastening units 40a, 40b and a screw 52 fastenable in the boss 51.

Further, a height H2 of the boss 51 may be lower than the above-mentioned height H1 such that the circuit board 30 is further pressed against the first and second protrusions 43, 44 when the auxiliary fastening unit 50 is assembled between the circuit board and the chassis base.

In addition, the first and second fastening units 40a, 40b and the auxiliary fastening unit 50 may be made of metallic material such that the circuit board 30 is electrically connectable to the chassis base 20.

According to exemplary embodiments of the invention, the assembly process for a display device can be simplified and shortened, and production damage can be minimized. Further, a pressing force can be increased between the circuit board and the main fastening unit. Additionally, the circuit board may be electrically connected to the chassis base through the fastening units to secure electrical stability.

Although the present invention has been described with reference to exemplary embodiments and the accompanying drawings, the present invention is not limited thereto. It will be appreciated by those skilled in the art that various changes and modifications may be made without departing from the principles and spirit of the invention, the scope of which is defined in the claims and their equivalents.

## Claims

1. A display device comprising
a display panel;
a chassis base having a first surface for supporting and for fixing the display panel thereto;
a circuit board fixed on a second surface opposite the first surface of the chassis base, the circuit board having circuit elements for driving the display panel; and
at least one main fastening unit fixable to the chassis base for spacing and fastening in place the circuit board and the chassis base,
wherein the at least one main fastening unit includes:
a main body fixable to the chassis base; and
a plurality of fasteners extending from the main body with a gap formed between neighboring fasteners, engageable portions being provided on outer circumferential surfaces of each fastener, such that each fastener is insertable into a fastening hole of the circuit board and is fastenable thereto.

2. The display device according to claim 1, wherein each of the fasteners includes a first protrusion insertable through the fastening hole of the circuit board to apply pressure to the chassis base, and a second protrusion coming into contact with an interfacial surface of the circuit board to support the circuit board such that the engageable portion is interposed between the first protrusion and the second protrusion.

3. The display device according to claim 2,
wherein there are at least two main fastening units, and
wherein an auxiliary fastening unit is provided adjacent to at least one of the at least two fastening units to fix the circuit board to the chassis base.

4. The display device according to claim 3, wherein the auxiliary fastening unit includes a boss located between the circuit board and the chassis base and having a screw fastening the circuit board to the boss.

5. The display device according to claim 4, wherein a length of the boss is less than a distance between the circuit board and the chassis base.

6. A display device according to claim 1, wherein the main fastening unit is made of a metallic material for electrically connecting the circuit board to the chassis base.

7. A display device according to claim 3, wherein the auxiliary fastening unit is made of a metallic material for electrically connecting the circuit board to the chassis base.

8. The display device of claim 1, wherein the display device is a plasma display device.

9. A method for spacing and fastening in place a chassis base to a circuit board, the method comprising:
providing a main fastening unit including a main body fixable to the chassis base and having a plurality of fasteners extending from the main body, the plurality of fasteners having engageable portions thereon such that the engageable portions engage the circuit board;
fixing the main fastening unit to the chassis base; and
inserting the main fastening unit into the circuit board to allow the engageable portions to engage the circuit board.

10. A fastener for spacing a circuit board and a chassis base comprising:
a main body fixable to the chassis base;
a plurality of fasteners extending from the main body with a gap formed between neighboring fasteners, engageable portions being provided on outer circumferential surfaces of each fastener, such that each fastener is insertable into the circuit board and is fastenable thereto.

11. The fastener of claim 10, wherein the fastener includes a first protrusion insertable through a fastening hole of the circuit board to apply pressure to the chassis base, and a second protrusion coming into contact with an interfacial surface of the circuit board to support the circuit board such that the engageable portion is interposed between the first protrusion and the second protrusion.

12. The fastener of claim 10, wherein the fastener is made of a metallic material for electrically connecting the circuit board to the chassis base.
